# EUROPÄISCHE PATENTSCHRIFT

(11) **EP 0 821 474 B1**
(45) Veröffentlichungstag und Bekanntmachung des Hinweises auf die Patenterteilung: **06.06.2001**
(21) Anmeldenummer: 97112722.0
(22) Anmeldetag: 24.07.1997
(51) Int. Cl.: H03F 3/08, H03F 3/347

(54) **Kombination aus Eingangsstufe und symmetrischen Transimpedanzverstärker**
Combination of an input stage and a symmetrical transimpedance amplifier
Combinaison d'un étage d'entrée et d'un amplificateur symétrique à transimpédance

(30) Priorität: 25.07.1996 DE 19630046
(43) Veröffentlichungstag der Anmeldung: 28.01.1998
(73) Patentinhaber: Infineon Technologies AG, 81669 München (DE)
(72) Erfinder: Herrle, Jürgen, Dipl.-Ing., 85051 Ingolstadt (DE)
(74) Vertreter: Zedlitz, Peter, Dipl.-Inf.

(56) Entgegenhaltungen:
- EP-A- 0 219 183
- US-A- 3 474 345
- US-A- 4 464 630
- US-A- 5 410 282
- M. AMARANDOS: "IC FORMS DIFFERENTIAL LINE DRIVER/RECEIVER" EDN ELECTRICAL DESIGN NEWS., Bd. 40, Nr. 11, 25.Mai 1995, NEWTON, MASSACHUSETTS US, Seite 90 XP000520333

## Beschreibung

Die Erfindung betrifft eine Kombination aus Eingangsstufe und symmetrischen Transimpedanzverstärker.

Beispielsweise bei optischer Signalübertragung wird das von einer Fotodiode gelieferte, unsymmetrische Signal von einem Transimpedanzverstärker verstärkt. Um die Störsicherheit des Verstärkers zu erhöhen, wird anschließend aus dem unsymmetrischen Signal ein symmetrisches Signal erzeugt. Aus N. Neuhäuser, Low-Noise, High-Transimpedance Si-Bipolar AGC Amplifier for 10Gb/s Optical-Fiber links, IEEE Photonics Technology Letters, Vol. 7, No. 5, Mai 1995, Seiten 549 bis 551, ist bekannt, zur Symmetrierung eines unsymmetrischen Eingangssignals das unsymmetrische Eingangssignal an einen Eingang einer Differenzverstärkerstufe zu legen und deren anderen Eingang an ein spezielles, im wesentlichen konstantes Referenzpotential anzuschließen. Zur Anspassung des Referenzpotentials an die Eingangssignalverhältnisse ist eine Regelschaltung mit verhältnismäßig hohem schaltungstechnischen Aufwand notwendig.

Aufgabe der Erfindung ist es, eine Eingangsstufe für einen Transimpedanzverstärker anzugeben, die einen geringeren schaltungstechnischen Aufwand erfordert und eine hohe Symmetrierung gewährleistet.

Die Aufgabe wird durch eine Kombination gemäß Patentanspruch 1 gelöst. Ausgestaltungen und Weiterbildungen des Erfindungsgedankens sind Gegenstand von Unteransprüchen.

Bei der erfindungsgemäßen Eingangsstufe wird dabei das unsymmetrische Eingangssignal zum einen invertiert und zum anderen nicht invertiert, um ein symmetrisches Signal aus dem unsymmetrischen Eingangssignal zu gewinnen. Dadurch wird eine zusätzliche Regelschaltung zur Erzeugung des Referenzpotentials wie beim Stande der Technik, sowie eine dabei häufig notwendige externe Kapazität eingespart.

Dabei umfaßt die invertierende Verstärkerstufe einen Transistor in Kollektorschaltung und nachfolgend einen Transistor in Emitterschaltung. Zwischen Eingang und Ausgang dieser invertierenden Verstärkerstufe ist dabei ein Gegenkopplungswiderstand geschaltet. Zudem kann bei dieser invertierenden Verstärkerstufe -je nach Anwendungsfall- die zugehörige nichtinvertierende Verstärkerstufe durch eine direkte, passive Verbindung gegeben sein. Bei dieser Ausführungsform wird mit geringstem schaltungstechnischen Aufwand eine hohe Symmetrierung erreicht.

Ausgestaltungen der Erfindunge sehen vor, daß invertierende und nichtinvertierende Verstärkerstufe eingangsseitig einander parallel geschaltet sind oder daß eine invertierende und nachfolgend eine nichtinvertierende Verstärkerstufe bzw. zwei invertierende Verstärkerstufen in Reihe geschaltet sind.

Schließlich können die symmetrischen Signale an die Eingänge einer Differenzverstärkerstufe angelegt werden, an deren Ausgängen Signale mit weiter verbesserter Symmetrie abgenommen werden können.

Die Erfindung wird nachfolgend anhand der in den Figuren der Zeichnung dargestellten Ausführungsbeispiele näher erläutert. Es zeigt:
Figur 1 eine erste Schaltungsvariante,
Figur 2 eine zweite Schaltungsvariante,
Figur 3 eine dritte Schaltungsvariante und
Figur 4 eine Ausführungsform der beanspruchten Kombination.

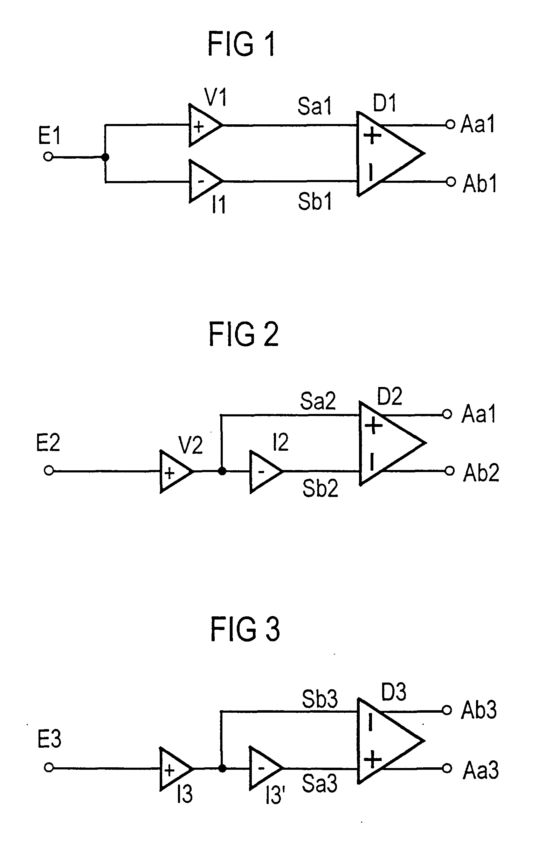

Bei dem Ausführungsbeispiel nach Figur 1 wird ein unsymmetrisches Eingangssignal E1 sowohl einem nichtinvertierendem Verstärker V1 als auch einem invertierendem Verstärker I1 zugeführt. Am Ausgang des nichtinvertierenden Verstärkers V1 tritt dabei das Signal Sal auf. Am Ausgang des invertierenden Verstärkers I1 ist ein zum Signal Sal symmetrisches Signal Sbl abgreifbar. Zur weiteren Symmetrierung sind die Signale Sal und Sbl dem nichtinvertierenden bzw. invertierenden Eingang einer Differenzverstärkerstufe D1 zugeführt, an deren Ausgängen weitere symmetrische Signale Aal und Ab1 auftreten.

Bei dem Ausführungsbeispiel nach Figur 2 wird ein unsymmetrisches Eingangs E2 nur einer nichtinvertierenden Verstärkerstufe V2 zugeführt, der wiederum eine invertierende Verstärkerstufe I2 nachgeschaltet ist. Als symmetrische Signale Sa2 und Sb2 fungieren wiederum die Ausgangssignale der beiden Verstärkerstufen V2 und I2, die ihrerseits an den nichtinvertierenden bzw. invertierenden Eingang einer Differenzverstärkerstufe D12 angelegt sind. An den Ausgängen der Differenzverstärkerstufe D2 stehen weitere symmetrische Signale Aa2 und Ab2 bereit.

Alternativ kann -wie in Figur 3 gezeigt- ein unsymmetrisches Eingangssignal E3 zunächst an eine invertierende Verstärkerstufe I3 angelegt werden, der wiederum eine invertierende Verstärkerstufe I3' nachgeschaltet ist. Die Ausgangssignale der Verstärkerstufen I3 und I3' bilden symmetrische Signale Sb3 und Sa3, die an den invertierenden bzw. nichtinvertierenden Eingang einer Differenzverstärkerstufe D3 angelegt sind. An den Ausgängen der Differenzverstärkerstufe D3 treten weitere symmetrische Signale Aa3 und Ab3 auf.

Gegenüber der Ausführungsform nach Figur 1 haben die Ausführungsformen nach Figur 2 und 3 den Vorteil, daß die Eingänge der Verstärkerstufen nicht parallel geschaltet sind, wodurch sich beispielsweise ein höherer Eingangswiderstand erzielen läßt.

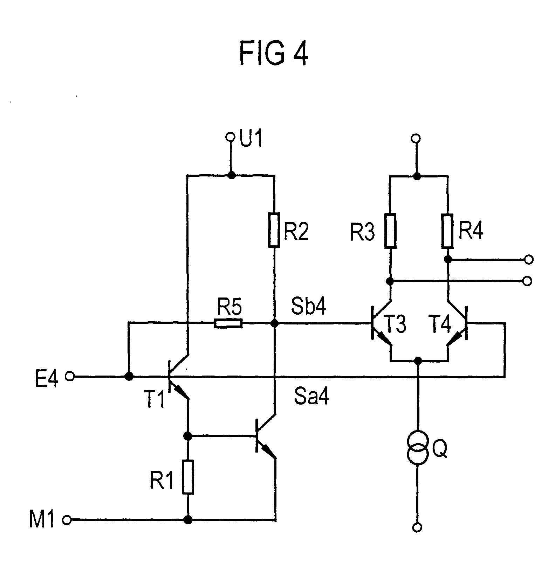

In Figur 4 ist eine Ausführungsform der erfindungsgemäßen Eingangsstufe dargestellt. Die invertierende Verstärkerstufe wird dabei durch einen Transistor T1 in Verbindung mit einem Widerstand R1 in Kollektorschaltung betrieben. Demnach ist der Kollektor des Transistors T1 direkt mit einem Versorgungspotential U1 verbunden und sein Emitter über den Widerstand R1 mit einem Bezugspotential M1 gekoppelt. An die Basis des Transistors T1 ist ein Eingangssignal E4 angelegt. Dem nachgeschaltet ist ein in Verbindung mit einem Widerstand R2 in Emitterschaltung betriebener Transistor T2. Somit ist der Emitter des Transistors T2 mit dem Bezugspotential M1, seine Basis mit dem Emitter des Transistors T1 und sein Kollektor über den Widerstand R2 mit dem Versorgungspotential U1 verbunden. Darüber hinaus ist der Kollektor des Transistors T2 über einen Widerstand R5 mit der Basis des Transistors T1 gekoppelt. Zwei zueinander symmetrische Signale Sa4 und Sb4 werden nun dadurch gebildet, daß zum einen das Eingangssignal E4 selbst als Signal Sa4 fungiert und am Kollektor des Transistors T2 das Signal Sb4 abgenommen wird. Das Signal Sb4 wird anschließend der Basis eines Transistors T3 und das Signal Sa4 der Basis eines Transistors T4 zugeführt. Die Emitter der beiden Transistors T3 und T4 sind miteinander gekoppelt und über eine Stromquelle Q mit einem Bezugspotential M2 verbunden. Ihre Kollektoren sind über jeweils einen Widerstand R3 bzw. R4 mit einem Versorgungspotential U2 gekoppelt und führen weitere symmetrische Signale Aa4 und Ab4.

Bei dem Ausführungsbeispiel nach Figur 4 wird die nichtinvertierende Verstärkerstufe durch eine Leitungsverbindung ersetzt, die in dem Fall eine Verstärkerstufe mit der Verstärkung 1 darstellt. Es kann aber in gleicher Weise auch eine aktive Verstärkerstufe mit gleicher oder unterschiedlicher Verstärkung verwendet werden. Die mit den Transistoren T1 und T2 gebildete invertierende Verstärkerstufe kann beispielsweise ebenfalls die Verstärkung 1 aufweisen. Sie kann aber auch eine höhere Verstärkung haben, sofern eine Differenzverstärkerstufe wie beim Ausführungsbeispiel nachgeschaltet ist.

## Patentansprüche

1. Kombination aus Eingangsstufe und symmetrischem Transimpedanzverstärker (D1-D4), wobei die Eingangsstufe ein unsymmetrisches Eingangssignal (E1-E4) zum einen nichtinvertiert und zum anderen, unter Zwischenschaltung einer invertierenden Verstärkerstufe (I1-I4), invertiert dem symmetrischen Transimpedanzverstärker zuführt, so daß am Transimpedanzverstärker symmetrische Signale (Sal bis Sa4) anliegen,
wobei die invertierende Verstärkerstufe (14) einen Transistor (T1) in Kollektorschaltung und nachfolgend einen Transistor (T2) in Emitterschaltung umfaßt, wobei Eingang und Ausgang der invertierenden Verstärkerstufe (14) über einen Widerstand (R5) gegengekoppelt ist.

2. Kombination nach Anspruch 1,
**dadurch gekennzeichnet,** daß
das unsymmetrische Eingangssignal (E1 bis E4) dem Transimpedanzverstärker zudem über einen nichtinvertierenden Verstärker (V1 bis V4) der Eingangsstufe zuführbar ist.

3. Kombination nach Anspruch 2,
**dadurch gekennzeichnet**, daß invertierende (I1) und nichtinvertierende (V1) Verstärkerstufe der Eingangsstufe eingangsseitig einander parallel geschaltet sind.

4. Kombination nach Anspruch 2,
**dadurch gekennzeichnet**, daß nichtinvertierende (V2) und invertierende (I2) Verstärkerstufe der Eingangsstufe in Reihe geschaltet sind.

5. Kombination nach Anspruch 1 ,
**dadurch gekennzeichnet**, daß innerhalb der Eingangsstufe zwei invertierende (I3, I3') Verstärkerstufen in Reihe geschaltet sind.

6. Kombination nach einem der Ansprüche 1 bis 5,
**dadurch gekennzeichnet**, daß die symmetrischen Signale (Sal bis Sa4, Sbl bis Sb4) an die Eingänge einer Differenzverstärkerstufe (D1 bis D4) angelegt sind, an deren Ausgängen weitere symmetrische Signale (Aa1 bis Aa4, Ab1 bis Ab4) abnehmbar sind.

## Claims

1. Combination of an input stage and a balanced transimpedance amplifier (D1 to D4), with the input stage supplying an unbalanced input signal (E1 to E4) to the balanced transimpedance amplifier firstly in a non-inverting manner and secondly in an inverting manner with the interposition of an inverting amplifier stage (I1 to I4), so that balanced signals (Sa1 to Sa4) are applied to the transimpedance amplifier, with the inverting amplifier stage (I4) comprising a transistor (T1) in a common-collector circuit followed by a transistor (T2) in a common-emitter circuit, and with the input and output of the inverting amplifier stage (14) having negative feedback via a resistor (R5).

2. Combination according to Claim 1,
characterized in that the unbalanced input signal (E1 to E4) can also be supplied to the transimpedance amplifier via a non-inverting amplifier (V1 to V4) in the input stage.

3. Combination according to Claim 2
characterized in that the inverting (I1) and the non-inverting (V1) amplifier stage in the input stage are connected in parallel with one another on the input side.

4. Combination according to Claim 2,
characterized in that the non-inverting (V2) and the inverting (I2) amplifier stage in the input stage are connected in series.

5. Combination according to Claim 1,
characterized in that, within the input stage, two inverting (I3, 13') amplifier stages are connected in series.

6. Combination according to one of Claims 1 to 5,
characterized in that the balanced signals (Sa1 to Sa4, Sb1 to Sb4) are applied to the inputs of a differential amplifier stage (D1 to D4) at whose outputs further balanced signals (Aa1 to Aa4, Ab1 to Ab4) can be tapped off.

## Revendications

1. Combinaison d'un étage d'entrée et d'un amplificateur (D1 à D4) symétrique d'adaptation d'impédance, l'étage d'entrée envoyant un signal (E1 à E4) d'entrée non symétrique d'une part de manière non inverseuse et d'autre part, avec interconnexion d'un étage (I1 à I4) amplificateur inverseur, de manière inverseuse à l'amplificateur symétrique d'adaptation d'impédance, si bien qu'il s'applique à l'amplificateur d'adaptation d'impédance des signaux (Sa1 à Sa4) symétriques,
l'étage (I4) d'amplificateur inverseur comprenant un transistor (T1) en circuit collecteur et en aval un transistor (T2) en circuit émetteur, l'entrée et la sortie de l'étage (I4) amplificateur inverseur étant rétrocouplé par l'intermédiaire d'une résistance (R5).

2. Combinaison suivant la revendication 1, caractérisée en ce que le signal (E1 à E4) d'entrée non symétrique peut être envoyé à l'amplificateur d'adaptation d'impédance de plus par l'intermédiaire d'un amplificateur (V1 à V4) non inverseur.

3. Combinaison suivant la revendication 2, caractérisée en ce que l'étage (I1) d'amplificateur inverseur et l'étage (V1) d'amplificateur non inverseur de l'étage d'entrée sont branchés en parallèle l'un à l'autre côté entrée.

4. Combinaison suivant la revendication 2, caractérisée en ce que l'étage (V2) d'amplificateur non inverseur et l'étage (I2) d'amplificateur inverseur de l'étage d'entrée sont branchés en série.

5. Combinaison suivant la revendication 1, caractérisée en ce que deux étages (I3, I3') d'amplificateur inverseur sont branchés en série à l'intérieur de l'étage d'entrée.

6. Combinaison suivant l'une des revendications 1 à 5, caractérisée en ce que les signaux (Sa1 à Sa4, Sb1 à Sb4) symétriques sont appliqués aux entrées d'un étage (D1 à D4) d'amplificateur différentiel aux sortie duquel d'autres signaux (Aa1 à Aa4, Ab1 à Ab4) symétriques peuvent être prélevés.
